# EUROPEAN PATENT SPECIFICATION

(11) **EP 2 290 697 B1**
(45) Date of publication and mention of the grant of the patent: **06.07.2016**
(21) Application number: 10174803.6
(22) Date of filing: 01.09.2010
(51) Int. Cl.: H01L 29/78, H01L 29/06, H01L 21/336, H01L 29/10, H01L 29/417

(54) **Method of making high-voltage semiconductor device with column structures**
Verfahren zur Herstellung einer Hochspannungshalbleiteranordnung mit Spaltenstrukturen
Procédé de fabrication d'un dispositif semi-conducteur haute tension ayant des structures en colonne

(30) Priority: 01.09.2009 IT MI20091522
(43) Date of publication of application: 02.03.2011
(73) Proprietor: STMicroelectronics Srl, 20864 Agrate Brianza (IT)
(72) Inventor: Saggio, Mario Giuseppe, 95021 Aci Castello (Catania) (IT); Murabito, Domenico, 95128 Catania (IT); Magrí, Angelo, 95032 Belpasso (Catania) (IT)
(74) Representative: Cerbaro, Elena

(56) References cited:
- EP-A2- 1 267 415
- US-A1- 2008 038 850

## Description

### Field of application

The present invention relates to a process for manufacturing a structure for a high voltage device, the process being of the type which comprises the steps of:
- realising a semiconductor substrate having a first conductivity type;
- epitaxially growing on said semiconductor substrate an epitaxial layer having the first conductivity type; and
- realising in said epitaxial layer at least one deep trench having a ratio between width and height being less than 3/20 in order to realise at least one respective column structure comprising said at least one deep trench in said epitaxial layer.

The invention particularly, but not exclusively, relates to a vertical conduction MISFET device which is driven through a gate dielectric and the following description is made with reference to this field of application for convenience of explanation only.

### Prior art

As it is well known, in the field of high voltage power semiconductor devices, several efforts have been addressed to provide solutions that improve the efficiency of these devices, and in particular obtain an increase of the breakdown voltage (BV) and a reduction of the output or on resistance (Ron) thereof.

In the development trend following the evolution of the high voltage power devices, the approach having the best compromise between breakdown voltage and on resistance is the so called SuperJunction approach, which provides for realising a plurality of three-dimensional structures (3D) as drain structures. Different manufacturing methods of these three-dimensional drain structures are aimed to realise a structure integrating columns or column structures, in particular having a first conductivity type, for instance of the p type, able to counterbalance the opposite charge, in particular of the opposite conductivity type, for instance the n type, of the drain layer wherein said column structures are realised, in particular in the portion of said layer extending between subsequent pairs of column structures.

These devices, so called Multi Drain (MD), thus work on the basis of the charge balance concept within the drain structure, being considered as the column structures and the drain layer as a whole.

Known solutions are described for instance in the US patents No.s US 6,228,719, US 6,300,171, US 6,404,010, US 6,586,798 and US 7,498,619 in the name of the present Applicant, in particular relating to vertical conduction power semiconductor devices of the Multi Drain type. Other solutions are known from the US Patent Application No. US 2008/0038850 in the name of Yamaguchi et al. and from the European Patent Application No. 1 267 415 in the name of Toshiba.

The devices disclosed in these documents substantially comprise, within a drain epitaxial layer, of a first conductivity type, charge balanced column structures, having a second conductivity type, opposed than the first type.

In particular, the column structures are realised with a dopant concentration which is substantially equal and opposite to the dopant concentration of the drain layer, so as to obtain a substantial charge balance which allows to obtain high breakdown voltages. Advantageously, by using a drain layer which has a high dopant concentration, devices are realised which have a low on resistance and thus reduced conduction losses.

Generally, making column structures comprises a sequence of steps of growing epitaxial layers of the first conductivity type, for instance of the N type, each step being followed by a dopant implantation of the second conductivity type, for instance of the P type.

Regions of the P type being so implanted are in particular realised so as to be stacked up in the depth development sense of the drain epitaxial layer wherein they are made and are subjected to a following diffusion process of the dopant atoms, in such a way to originate uniform column structures.

Above the drain epitaxial layer, in contact with the column structures, active regions of the high voltage device are realised, in particular body wells, the column structures thus providing extensions of said body wells inside the drain layer.

In essence, Multi Drain devices so realised are characterised by combining a high cut-off voltage with reduced losses thanks to the charge balance between a conduction region, namely the drain region between the columns and the column structures extending into the drain layer, which allow to increase the concentration of such a conduction region obtaining a strong reduction of conduction losses.

Other method to realise Multi Drain devices having a charge compensation are known for example from the articles: "A Novel Trench Concept for the Fabrication of Compensation Devices" to Rüb et al., ISPSD, April 14-17, 2003, Cambridge, UK, "Oxide-Bypassed VDMOS (OBVDMOS): An Alternative to Superjunction High Voltage MOS Power Devices" to Liang et al., IEEE Electron Devices Letters, Vol. 22, No. 8, August 2001, and "Experimental Results and Simulation Analysis of 250V Super Trench Power MOSFET (STM)" to Nitta et al., Mitsubishi Electric Co., ULSI Development Center, 12th International symposium on power semiconductor devices & Ics, Toulouse, May 22-25, 2000 as well as from the US Patent Application published under No. US 2001/0055861 on December 27, 2001 in the name of Patti et al. and from the US Patent No. US 6,410,958 issued on June 25, 2002 to Usui et al..

Even advantageous under several aspects, the known solutions to realise Multi Drain devices comprise a high number of process steps, thus turning out to be difficult to implement. Moreover, it often occurs that the dopant profile in the conduction region is not constant.

Finally, these known solution do not easily allow to extend the voltage class of the Multi Drain devices so obtained.

The technical problem underlying the present invention is that of manufacturing a structure for a high voltage device having structural and functional characteristics which allow to overcome the limits and drawbacks which still affect the devices realised according to the prior art.

### Summary of the invention

The solution idea underlying the present invention is that of manufacturing a structure for a high voltage device through a superjunction structure characterized in that it is obtained by partially filling a deep trench having a high aspect ratio, namely having a ratio between width and height less than 3/20, with an epitaxial layer doped in opposition with the preexisting semiconductor layer thus forming the column structures. The quantity of dopant being in the epitaxial layer would be the one counterbalancing the dopant being in the neighbouring conduction areas, i.e. the epitaxial layer 3 outside the column structures 4. The structure is also characterized in that it further comprises a dielectric layer able to completely fill said deep trench, being partially filled by said epitaxial layer.

In particular, the column structures are structures of the drain area and turn out to have a same periodicity of the active surface areas, being wells realising body areas, each drain column structure being "coupled" to a corresponding body well.

On the basis of such solution idea the technical problem is solved by a process for manufacturing a structure for a high voltage device, the process being of the type which comprises the steps of:
- realising a semiconductor substrate having a first conductivity type;
- epitaxially growing on said semiconductor substrate an epitaxial layer having said first conductivity type; and
- realising in said epitaxial layer at least one deep trench having a ratio between width and height being less than 3/20 in order to realise at least one respective column structure comprising said at least one deep trench in said epitaxial layer;
wherein the process further comprises:
- an epitaxial growing step within said at least one deep trench of a silicon layer of said at least one respective column structure, said silicon layer being doped and having a second conductivity type, opposed to said first conductivity type and having a dopant charge which counterbalances a dopant charge being in said epitaxial layer outside said column structures and
- a filling step of said trench by means of a filling dielectric layer in order to realise a filling portion of said at least one respective column structure, wherein
said epitaxial growing step grows a silicon layer having a dopant concentration with a variable concentration profile having a maximum near an interface with said epitaxial layer.

According to an aspect of the invention, said epitaxial growing step within said at least one deep trench could grow said silicon layer at least on the walls and on the bottom of said at least one deep trench thus realising an U-shaped external portion of said at least one respective column structure

According to this aspect of the invention, said epitaxial growing steps of said epitaxial layer on said semiconductor substrate and of said epitaxial layer within said at least one deep trench could be realised with a low thermal budget and with a process maximum temperature less than 1100°C.

Yet according to this aspect of the invention, said epitaxial growing steps could realise said epitaxial layer within said at least one deep trench with a dopant concentration comprised between 1e15 and 1e17 at/cm3, preferably 1e16 at/cm3, and said epitaxial layer on said semiconductor substrate with a dopant concentration comprised between 5e14 and 5e16 at/cm3, preferably 5e15.

According to another aspect of the invention, the process could comprise a step of realising a first active area of said structure by forming a plurality of said at least one column structures and could comprise a step of realising, in an active surface area of said structure, at least one second active area which has at least one zone in contact with said first active area.

The characteristics and advantages of the manufacturing process according to the invention will be apparent from the following description of an embodiment thereof given by way of indicative and non limiting example with reference to the annexed drawings.

### Brief description of the drawings

In such drawings:
Figure 1 schematically shows a section view of a structure for a high voltage device being realised according to the process of the invention;
Figure 2 schematically shows the dopant concentration profiles of an embodiment of the structure of Figure 1;
Figures 3A-3D schematically show section views of the structure of Figure 1 during different steps of the manufacturing process according to the invention.

### Detailed description

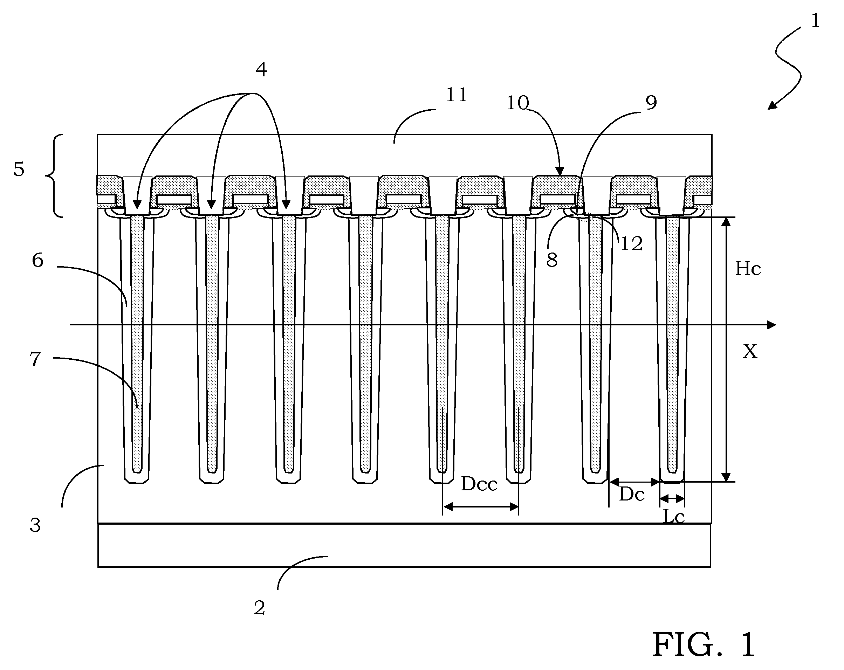

With reference to such figures, and in particular to Figure 1, 1 globally and schematically indicates a structure for a high voltage device realised according to the process of the invention.

It is suitable to note that figures showing schematic portions of the integrate structure are not drawn in scale, but are drawn in such a way to emphasise the important features of the invention.

Moreover, the process steps as herein below described do not form a complete process flow for manufacturing high voltage devices. The present invention can be reduced into practice along with techniques for manufacturing high voltage devices as currently used into the field, and only those process steps which are needed for understanding the present invention are included.

The structure 1 for a high voltage device comprises a semiconductor substrate 2 covered by an epitaxial layer 3, having a first conductivity type, in particular N type. Advantageously, a plurality of column structures 4 having a high aspect ratio, in particular less than 3/20, is realised in the epitaxial layer 3.

The structure 1 for a high voltage device further comprises an active surface area 5, wherein the active areas of the high voltage device are realised, as will be clarified in the following description.

Each of the column structures 4 comprises an external portion 6, in particular an epitaxial silicon layer being suitably doped, as well as a filling portion 7, in particular a dielectric layer, such as an oxide, being deposited inside the respective column structure 4 for completely filling it. The epitaxial silicon layer of the external portion 6 is doped and has a second conductivity type, in particular the P type.

The charge which is epitaxially inserted in order to realise the external portion 6 is such as to counterbalance the charge being in the epitaxial layer 3 outside the column structures 4. Moreover, the epitaxial layer, which realises the external portion 6 is on the walls and on the bottom of the corresponding column structure 4, which is realised, as will be clarified in the following description, starting from a trench being dug in the epitaxial layer 3, in particular a deep trench having a high aspect ratio, i.e. a low ratio between width and height, namely less than 3/20.

In the active surface area 5, a high voltage device is realised, in a conventional manner, of the type comprising at least an active area 8.

The column structures 4 have respective coupling zones 12 with the active areas 8, having a same periodicity thereof.

In particular, the structure 1 for a high voltage device realised according to the process of the invention comprises column structures 4 in turn realised by a U-shaped zone of semiconductor material, i.e. the external portion 6 of the epitaxial silicon, being suitably doped with a dopand of an opposite type with respect to the one of the neighbouring semiconductor material, i.e. the epitaxial layer 3 outside the column structures 4, this U-shaped external portion 6 being in turn filled by a dielectric layer to form the filling portion 7.

It is suitable to note that the charge quantity being in the epitaxial silicon layer of the U-shaped external portion 6 of the column structures 4 is such that a balance of the charge is obtained with respect to the epitaxial layer 3 outside the column structures 4 themselves.

In the example of Figure 1, a MOS transistor of the Multi Drain type is realised.

Therefore, in the example as shown, the MOS transistor comprises a drain epitaxial layer 3 being provided with a plurality of column structures 4 and an active surface area 5 wherein a plurality of body wells 8 are realised, having the second conductivity type, in particular the P type, inside which a corresponding plurality of source wells 9, of the first conductivity type, in particular the N type, is realised.

The high voltage MOS device of the example of Figure 1 is completed by realising a plurality of gate structures 10, being realised between consecutive pairs of column structures 4, above a channel region, being defined in the drain epitaxial layer 3 between the body wells 8 and in contact with the source wells 9.

The structure 1 for a high voltage device further comprises a covering or capping layer 11, being realised above the whole high voltage device and in particular covering the gate structures 10.

Finally, the structure 1 for a high voltage device could be provided, in a known manner, with surface contact structures of microtrench or conventional type.

Moreover, the gate structures 10 could be of the planar type or of the trench gate type.

The drain column structures 4, having a same periodicity than the body wells 8, have respective coupling zones 12 with the body wells 8 themselves. In particular, each of the column structures 4 comprises a pair of coupling zones 12 with the body wells 8 which bounds it at the upper side.

In a preferred embodiment of the structure 1 for a high voltage device realised according to the process of invention, each of the column structures 4 has a width Lc between 1,5 and 4µm, preferably 2µm and a height Hc between 10 and 70 µm, preferably 30µm, thus defining a maximum value of aspect ratio of the deep trench which constitutes the column structures 4 equal to 3/20.

Moreover, the epitaxial layer which realises the external portion 6 has a dopant concentration between 1e15 and 1e17, preferably 1e16 at/cm3, while the drain epitaxial layer 3 has a dopant concentration between 5e14 and 5e16, preferably 5e15.

In a further preferred embodiment, the column structures 4 have a distance Dc between 2µm and 8µm, preferably 4µm, and a distance Dcc between the symmetry axis of the column structures 4 between 2.5µm and 12µm, preferably 6µm.

In a preferred embodiment, the structure 1 for a high voltage device realised according to the process of the invention realises a 600V device.

By varying the height Hc of the column structures 4, it is however possible to easily obtain high voltage devices from 300V up to 2000V.

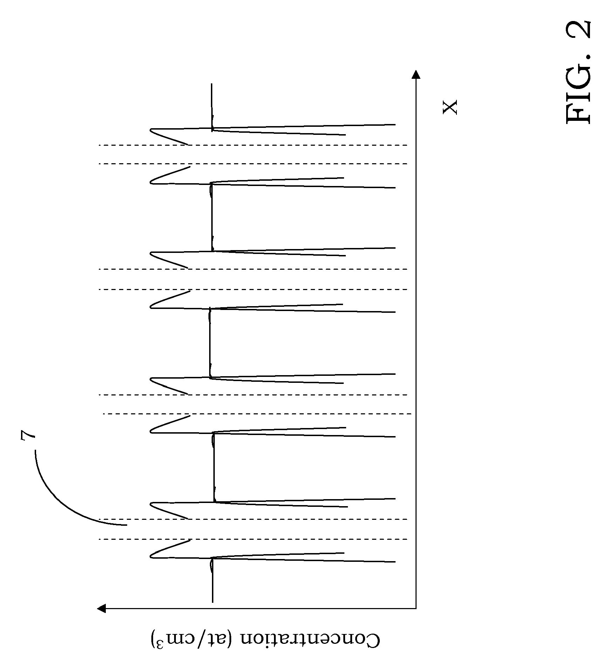

The dopant concentration along the column structures 4 of an embodiment of the structure 1 for a high voltage device is shown in Figure 2, X being the longitudinal development axis of the structure 1 itself, as also indicated in Figure 1. In particular, it is worth noting that the charge epitaxially introduced into the epitaxial layer which realises the U-shaped external portion 6 of the column structures 4 is such that it counterbalances the charge being in the epitaxial layer 3 outside the column structures 4 themselves, the filling portion 7 of such column structures 4 being instead realised by an oxide.

The dopant in the epitaxial layer forming the U-shaped external portion 6 of the column structures 4 is not constant, but it advantageously has a peak in correspondence with the interface with the epitaxial layer 3 outside the column structures 4 themselves.

According to this embodiment, the manufacturing process of the structure 1 for a high voltage device turns out to be well controlled since it is able to guarantee the charge balance between the U-shaped external portion 6 of the column structures 4 and the epitaxial layer 3 outside them (i.e. between the N zone and the P zone) without needing an extremely fine control of the thickness of the silicon epitaxial layer as grown in order to realise the U-shaped external portion 6. In particular, in the case under examination, changes into the thickness of the external portion 6 cause little changes on the total charge amount being contained into the silicon epitaxial layer of such external portion 6 thus making easier the process industrialisation.

While in the embodiment as shown in Figure 1 the column structures 4 do not reach the semiconductor substrate 2, it is obviously possible to take into account the case in which they reach it too.

Moreover, it is obviously possible to realise in the active surface area 5 a high voltage device different from a MOS transistor, such as for example a diode or an IGBT device.

In essence, it is possible to consider the structure 1 for a high voltage device realised according to the process of the invention as comprising a first active area being realised by the column structures 4 and a second active area 8 and having at least one coupling zone 12 which the first active area 4.

The second active area is "coupled" in correspondence with the coupling zone 12 to a conductive portion of the first active area, in particular of the column structures.

In the case shown in Figure 1, making a MOS transistor of the Multi Drain type, the first active area is the drain area while the second one is the body area. It is obvious for a technical expert in the field that, in the case for instance of a diode, such first and second active areas would be the cathode and anode areas.

Also in the exemplary case of Figure 1, the second active area is "coupled" in correspondence with the coupling zone 12 to the external portion 6 of the column structure 4, being a conductive portion of the first active area.

The present invention relates to a process for manufacturing a structure 1 for a high voltage device of the above indicated type.

This manufacturing process comprises the steps as defined in claim 1.

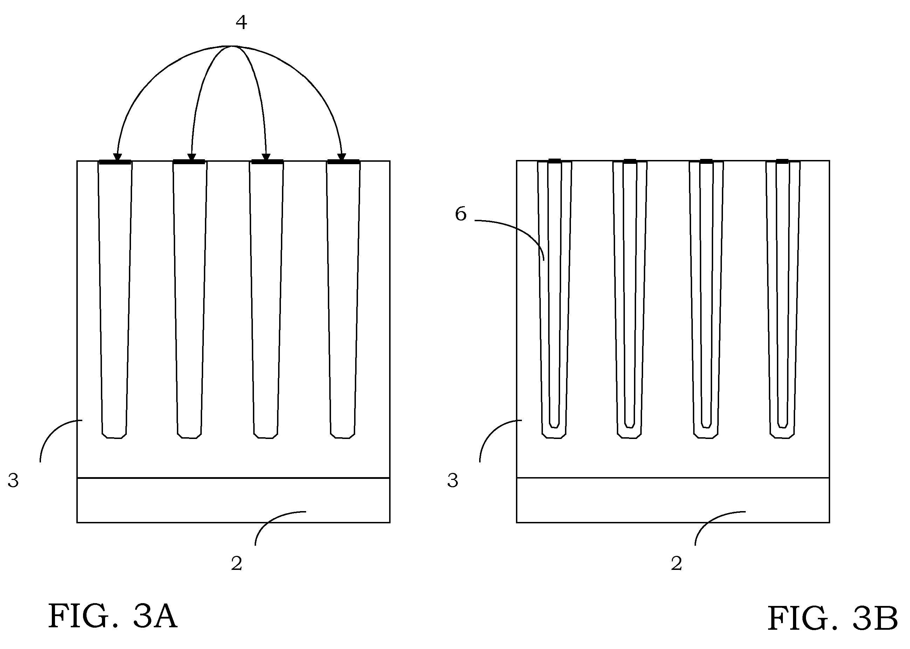

Realising in said epitaxial layer 3 at least a deep trench 4 having a high aspect ratio in order to realise at least one column structure is schematically shown in Figure 3A.

The process of the invention further comprises the step of epitaxially growing within the trench 4 a silicon layer 6, according to an embodiment being placed at least on the walls and on the bottom of the trench 4 so as to realise an external portion of a column structure 4 being thus formed into the epitaxial layer 3.

The epitaxial layer 6 having been grown to form such an external portion is doped with a dopant of a second type and in such a way that the dopant charge being epitaxially introduced counterbalances the charge of the dopant of the first type of the epitaxial layer 3 surrounding the trench 4, as schematically shown in Figure 3B.

Said epitaxial growing step advantageously grows an epitaxial layer 6 having a dopant concentration with a variable concentration profile having a maximum near an interface with the epitaxial layer 3.

Advantageously according to the invention, the steps of epitaxially growing the drain epitaxial layer 3 and the epitaxial layer 6 of the external portion of the column structures are realised with a limited thermal budget and a maximum process temperature less than 1100°C. In this way, the process according to the invention turns out to be compatible also with big sized wafers (for instance of 8" or 12") and it is possible to minimize the transition zone between the column structures 4 and the conduction zones, i.e. the portions of the drain epitaxial layer 3 outside said column structures 4.

In other words, a process having a low thermal budget is used in order to keep almost unaltered the dopant distribution inside the epitaxial layer 3 having been grown inside the trench 4 which makes the column structures.

In particular, the epitaxial growing steps realising the epitaxial layer 6 with a dopant concentration between 1e15 and 1e17 at/cm3, preferably 1e16 at/cm3, and a drain epitaxial layer 3 with a dopant concentration between 5e14 and 5e 16 at/cm3, preferably 5e15 at/cm3.

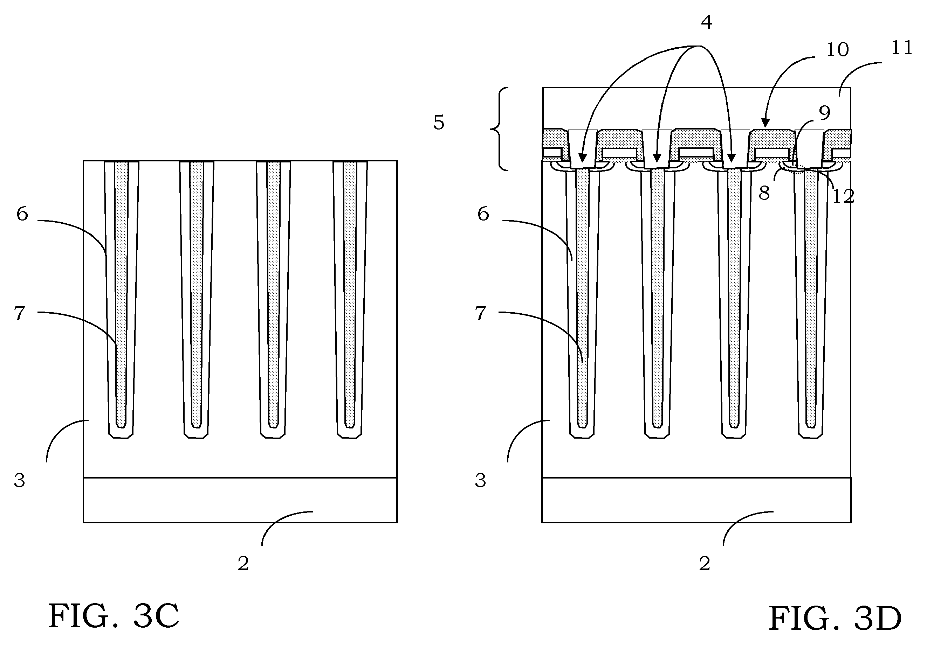

Furthermore, the process comprises a filling step of the trench 4 by means of a filling dielectric layer 7, in particular an oxide, in order to realise a filling portion of the column structure 4, as schematically shown in Figure 3C.

This filling step by means of the filling dielectric layer 7 completely fills the trench 4, guaranteeing the absence into the same, and thus into the column structure 4 so realized, of voids.

The process then comprises a step of realising, in an active surface area 5 of the structure 1, a high voltage device comprising at least an active area. In particular, as in the example shown in Figure 1, the high voltage device is a MOS transistor of the Multi Drain type comprising a drain area being realised by the epitaxial layer 3 and the column structures 4 and comprising source wells 9 being realised into body wells 8, these latter having been advantageously realised in contact with the column structures 4 in correspondence with coupling zones 12, as well as gate structures 10 being realized over channel regions being defined into the epitaxial layer 3 between the body wells 8 and in contact with the source wells 9, as schematically shown in Figure 3D.

It is thus obtained an integration process having a lower number of steps that a conventional technology of integration of Multi Drain transistors and thus being easier to implement.

Moreover, the charge balance being realised by the epitaxial layer 6 of the external portion of the column structures 4 with respect to the epitaxial layer 3 which surrounds them, allows to obtain a constant dopant profile in the conduction zone, the extension of the voltage class of the high voltage device so obtained being thus easier.

According to an embodiment of the invention, the use of an epitaxial growing step of the layer 6 allows to eliminate every problem of implant angle tied to the high aspect ratio of the trench 4, with a better doping control of the external portion 6 of the column structures 4.

Obviously, a technician of the field, aiming at meeting incidental and specific needs, will bring several modifications and alternatives to the above described structure and process. The scope of protection of the invention is defined by the following claims. In particular, it is possible, by using a drain layer of the P type and column structures of the N type, to obtain a structure for a high voltage device of a dual type.

## Claims

1. Process for manufacturing a structure (1) for a high voltage device, the process being of the type which comprises the steps of:
- realising a semiconductor substrate (2) having a first conductivity type;
- epitaxially growing on said semiconductor substrate (2) an epitaxial layer (3) having said first conductivity type; and
- realising in said epitaxial layer (3) at least one deep trench having a ratio between width and height being less than 3/20 in order to realise at least one respective column structure (4) comprising said at least one deep trench in said epitaxial layer (3);
wherein the process further comprises:
- an epitaxial growing step within said at least one deep trench of a silicon layer of said at least one respective column structure (4), said silicon layer being doped and having a second conductivity type opposed to said first conductivity type and having a dopant charge which counterbalances a dopant charge being in said epitaxial layer (3) outside said column structures (4) and
- a filling step of said trench by means of a filling dielectric layer in order to realise a dielectric filling portion (7) of said at least one respective column structure (4), wherein
said epitaxial growing step grows a silicon layer having a dopant concentration with a variable concentration profile having a maximum near an interface with said epitaxial layer (3).

2. Process according to claim 1, wherein said epitaxial growing step within said at least one deep trench grows said silicon layer at least on the walls and on the bottom of said at least one deep trench thus realising an U-shaped external portion (6) of said at least one respective column structure (4).

3. Process according to claim 1, wherein said epitaxial growing steps of said epitaxial layer (3) on said semiconductor substrate (2) and of said silicon layer within said at least one deep trench are realised with a low thermal budget and with a process maximum temperature less than 1100°C.

4. Process according to claim 3, wherein said epitaxial growing steps realise said silicon layer within said at least one deep trench with a dopant concentration comprised between 1e15 and 1e17 at/cm3, preferably 1e16 at/cm3, and said epitaxial layer (3) on said semiconductor substrate (2) with a dopant concentration comprised between 5e14 and 5e16 at/cm3, preferably 5e15 at/cm3.

5. Process according to claim 1, wherein a first active area of said structure (1) is realised by a plurality of said at least one column structures (4) and wherein it further comprises a step of realising, in an active surface area (5) of said structure (1), at least one second active area (8) which has at least one zone (12) in contact with said first active area.

## Patentansprüche

1. Verfahren zum Herstellen einer Struktur (1) für eine Hochspannungsvorrichtung, wobei das Verfahren derart gestaltet ist, dass es die folgenden Schritte beinhaltet:
- Bereitstellen eines Halbleitersubstrats (2) mit einem ersten Leitfähigkeitstyp;
- epitaktisches Aufwachsen einer Epitaxieschicht (3) mit dem ersten Leitfähigkeitstyp auf dem Halbleitersubstrat (2); und
- Bereitstellen mindestens eines tiefen Grabens in der Epitaxieschicht (3), der ein Verhältnis von Breite zu Höhe von weniger als 3/20 hat, um mindestens eine entsprechende Spaltenstruktur (4) bereitzustellen, die den mindestens einen tiefen Graben in der Epitaxieschicht (3) aufweist;
wobei das Verfahren ferner beinhaltet:
- einen Schritt des epitaktischen Aufwachsens einer Siliziumschicht der mindestens einen entsprechenden Spaltenstruktur (4) in dem mindestens einen tiefen Graben, wobei die Siliziumschicht dotiert ist und einen dem ersten Leitfähigkeitstyp entgegengesetzten zweiten Leitfähigkeitstyp und eine Dotierstoffladung, die eine Dotierstoffladung in der Epitaxieschicht (3) außerhalb der Spaltenstrukturen (4) ausgleicht, hat und
- einen Schritt des Füllens des Grabens mittels einer dielektrischen Füllschicht zum Bereitstellen eines dielektrischen Füllteils (7) der mindestens einen entsprechenden Spaltenstruktur (4), wobei
in dem Schritt des epitaktischen Aufwachsens eine Siliziumschicht mit einer Dotierstoffkonzentration mit einem variablen Konzentrationsprofil, das ein Maximum nahe einer Grenzfläche zu der Epitaxieschicht (3) hat, aufwächst.

2. Verfahren nach Anspruch 1, wobei in dem Schritt des epitaktischen Aufwachsens in dem mindestens einen tiefen Graben die Siliziumschicht mindestens an den Wänden und dem Boden des mindestens einen tiefen Grabens aufwächst und somit einen U-förmigen äußeren Teil (6) der mindestens einen entsprechenden Spaltenstruktur (4) bereitstellt.

3. Verfahren nach Anspruch 1, wobei die Schritte des epitaktischen Aufwachsens der Epitaxieschicht (3) auf dem Halbleitersubstrat (2) und der Siliziumschicht in dem mindestens einen tiefen Graben mit einer geringen Wärmebilanz und einer maximalen Verfahrenstemperatur von weniger als 1100 °C bereitgestellt werden.

4. Verfahren nach Anspruch 3, wobei die Schritte des epitaktischen Aufwachsens die Siliziumschicht in dem mindestens einen tiefen Graben mit einer Dotierstoffkonzentration zwischen 1e15 und 1e17 at/cm3, vorzugsweise 1e16 at/cm3, und die Epitaxieschicht (3) auf dem Halbleitersubstrat (2) mit einer Dotierstoffkonzentration zwischen 5e14 und 5e16 at/cm3, vorzugsweise 5e15 at/cm3, bereitstellen.

5. Verfahren nach Anspruch 1, wobei ein erster aktiver Bereich der Struktur (1) durch eine Mehrzahl der Spaltenstrukturen (4), von denen es mindestens eine gibt, bereitgestellt wird, und das ferner einen Schritt des Bereitstellens mindestens eines zweiten aktiven Bereichs (8), der mindestens eine Zone (12) in Kontakt mit dem ersten aktiven Bereich hat, in einem aktiven Oberflächenbereich (5) der Struktur (1) beinhaltet.

## Revendications

1. Procédé de fabrication d'une structure (1) pour un dispositif haute tension, le procédé étant du type qui comprend les étapes de :
- réalisation d'un substrat semi-conducteur (2) ayant un premier type de conductivité ;
- croissance épitaxiale sur ledit substrat semi-conducteur (2) d'une couche épitaxiale (3) ayant ledit premier type de conductivité ; et
- réalisation dans ladite couche épitaxiale (3) d'au moins une tranchée profonde ayant un rapport entre la largeur et la hauteur qui est inférieur à 3/20 afin de réaliser au moins une structure de colonne respective (4) comprenant ladite au moins une tranchée profonde dans ladite couche épitaxiale (3) ;
dans lequel le procédé comprend en outre :
- une étape de croissance épitaxiale, au sein de ladite au moins une tranchée profonde, d'une couche de silicium de ladite au moins une structure de colonne respective (4), ladite couche de silicium étant dopée et ayant un second type de conductivité opposé audit premier type de conductivité et ayant une charge de dopant qui contrebalance la charge de dopant se trouvant dans ladite couche épitaxiale (3) à l'extérieur desdites structures de colonne (4) et
- une étape de remplissage de ladite tranchée au moyen d'une couche diélectrique de remplissage afin de réaliser une partie de remplissage diélectrique (7) de ladite au moins une structure de colonne respective (4), dans lequel
ladite étape de croissance épitaxiale fait croître une couche de silicium ayant une concentration en dopant avec un profil de concentration variable ayant un maximum près d'une interface avec ladite couche épitaxiale (3).

2. Procédé selon la revendication 1, dans lequel ladite étape de croissance épitaxiale au sein de ladite au moins une tranchée profonde fait croître ladite couche de silicium au moins sur les parois et sur le fond de ladite au moins une tranchée profonde, réalisant ainsi une partie externe en forme de U (6) de ladite au moins une structure de colonne respective (4).

3. Procédé selon la revendication 1, dans lequel lesdites étapes de croissance épitaxiale de ladite couche épitaxiale (3) sur ledit substrat semi-conducteur (2) et de ladite couche de silicium au sein de ladite au moins une tranchée profonde sont réalisées avec un faible budget thermique et avec une température maximale de procédé inférieure à 1100 °C.

4. Procédé selon la revendication 3, dans lequel lesdites étapes de croissance épitaxiale réalisent ladite couche de silicium au sein de ladite au moins une tranchée profonde avec une concentration en dopant comprise entre 1e15 et 1e17 at/cm³, de préférence 1e16 at/cm³, et ladite couche épitaxiale (3) sur ledit substrat semi-conducteur (2) avec une concentration en dopant comprise entre 5e14 et 5e16 at/cm³, de préférence 5e15 at/cm³.

5. Procédé selon la revendication 1, dans lequel une première région active de ladite structure (1) est réalisée par une pluralité de ladite au moins une structure de colonne (4) et dans lequel il est en outre compris une étape de réalisation, dans une région de surface active (5) de ladite structure (1), d'au moins une deuxième région active (8) qui a au moins une zone (12) en contact avec ladite première région active.
